Europäisches Patentamt

European Patent Office

Office européen des brevets

(19)

(11) Publication number: **0 206 468**
**A1**

# EUROPEAN PATENT APPLICATION

(12)

(21) Application number: 86302993.0

(22) Date of filing: 21.04.86

(51) Int. Cl.⁴: **G 01 R 31/28, G 06 F 11/22**

(30) Priority: 02.05.85 GB 8511188

(43) Date of publication of application: 30.12.86
Bulletin 86/52

(84) Designated Contracting States: BE DE FR GB IT NL

(71) Applicant: INTERNATIONAL COMPUTERS LIMITED, ICL
House, Putney, London, SW15 1SW (GB)

(72) Inventor: Hale, Stuart George, 101 Dane Road, Denton
Manchester M34 2HY (GB)

(74) Representative: Guyatt, Derek Charles et al, STC
Patents Edinburgh Way, Harlow Essex CM20 2SH (GB)

(54) **Testing digital integrated circuits.**

(57) A digital integrated circuit is described, having a logic
circuit (10) and a linear feedback shift register (12) for pro-
ducing pseudo-random sequences of test patterns for the lo-
gic circuit. The feedback connections (16) for the shift regis-
ter are confined to a portion (B0–B7) of the shift register, so
that the full sequence length of the test patterns is not ex-
cessively long. The patterns generated in this portion of the
shift register are shifted along into the rest of the register so
that the same sequence is applied to each group of adjacent
inputs of the logic circuit (10). This is especially useful for
testing circuits with a repetitive structure.

## TESTING DIGITAL INTEGRATED CIRCUITS

This invention relates to testing digital integrated circuits.

One known method of testing a digital integrated circuit is to use a pseudo-random number generator to produce a sequence of test patterns. These patterns are applied to the input of the circuit to be tested, and the output of the circuit is then observed and compared with the expected value. A convenient form of pseudo-random number generator is a linear feedback shift register, and it may conveniently be integrated on the same chip as the circuit to be tested.

For example, US Patent No. 3 961 252 describes an integrated circuit having registers which normally act as buffers for data and addresses. In a test mode, these registers are converted into linear feedback shift registers for generating test patterns. Alternatively, the registers can be converted into simple shift registers, connected together in series to allow data to be scanned serially into or out of the registers for diagnostic purposes.

A convenient way of performing such a test is to run the feedback shift register through its full sequence, consisting of $2^n-1$ different patterns, where $n$ is the number of bits in the register. (One possible pattern, usually the all-zeros pattern, is missing from the normal linear feedback shift register sequence). This ensures that the circuit under test receives every possible input pattern, apart from the missing one.

However, if the register is large, the full sequence may be extremely long. For example, for a 32-bit register the length of the sequence is approximately 4000 million patterns, which would take an excessively long time to run. For this reason, the use of the full pattern sequence is limited to registers of about 20 bits, corresponding to approximately one million patterns.

One way of avoiding this problem for longer registers is to use only a selected part of the full sequence for the test. However, it is very difficult to choose a suitable part of the sequence to give the best fault coverage of the circuit under test. In particular, great care must be taken to ensure that important test patterns are not missing from the chosen part of the sequence.

The object of the present invention is to avoid this difficulty.

SUMMARY OF THE INVENTION

According to the invention, there is provided a digital integrated circuit comprising a logic circuit having a plurality of inputs, connected to respective outputs of an $n$-stage shift register having a feedback circuit for applying a feedback signal to the first stage of the shift register to cause the shift register to act as a linear feedback shift register, the feedback circuit having connections from the outputs of predetermined stages of the shift register, these connections being confined to the first $m$ stages of the shift register where $m$ is less than $n$.

It can be seen that a full pattern sequence generated in the first $m$ stages of the shift register contains only $2^m-1$ patterns. These patterns will be shifted along the register into the remaining stages, so that every group of $m$ adjacent stages will receive the same sequence of patterns. This arrangement is very effective for testing regularly repeated circuits, which are very common in integrated circuits.

This shift register may also include a further feedback circuit with connections which are not confined in the same way as the connections to the first mentioned feedback circuit. This further feedback circuit may be used in other modes of operation, e.g. when the register is being used as a signature analyser register.

One embodiment of the invention will now be described by way of example with reference to the accompanying drawings.

BRIEF DESCRIPTION OF THE DRAWINGS

Figure 1 is a block circuit diagram of an integrated circuit chip including a test pattern generator.

Figure 2 shows one bit cell of the test pattern generator in detail.

DETAILED DESCRIPTION

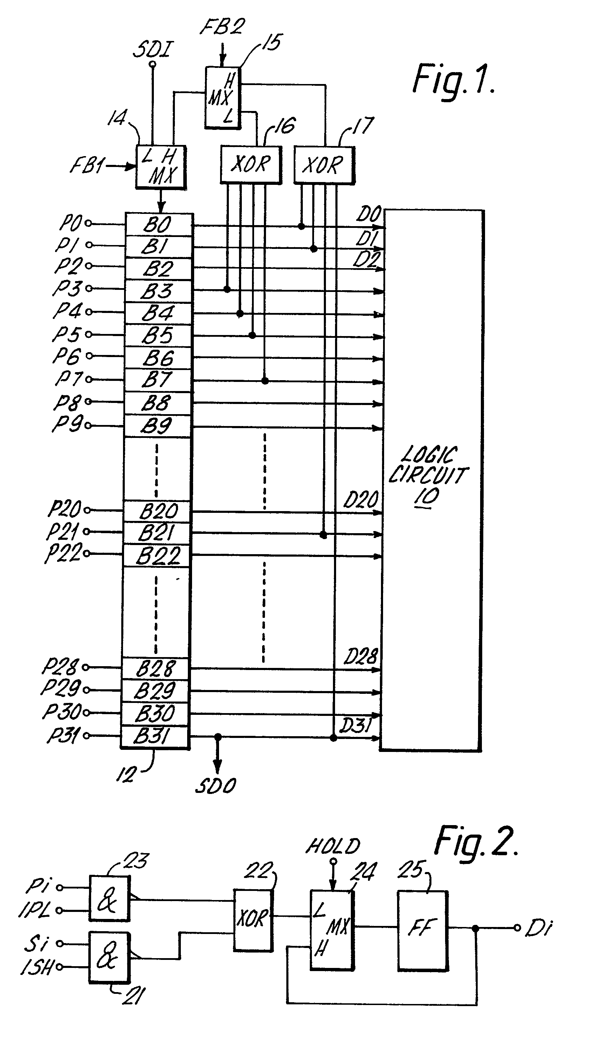

Referring to Figure 1, this shows an integrated circuit chip including a logic circuit 10. The exact nature of this circuit forms no part of the invention. For example, it may be a shift matrix or a set of highway driver circuits.

The integrated circuit chip also includes a 32-bit register 12, having bit cells B0-B31. This register has 32 parallel data inputs P0-P31, which may be connected to other logic circuits on the chip (not shown) or to external terminals. The register also has 32 data outputs D0-D31 which are connected to respective inputs of the logic circuit 10. In normal operation, the register 12 acts as an input data buffer for the logic circuit 10. However, as will be described, in other modes of operation, the register can be operated as a shift register for serially shifting test data into or out of the chip, as a pseudo-random number generator for generating sequences of test patterns for the logic circuit 10, or as a digital signature analyser for producing a signature characteristic of a sequence of inputs.

Referring now to Figure 2, this shows one of the bit cells B$i$ of the register, where $i$ = 0,1----31.

The cell has a serial data input S$i$ which is fed to a NAND gate 21, controlled by a signal ISH. The output of this gate is fed to one input of an exclusive -OR gate 22, the other input of which is connected to the output of a NAND gate 23. The gate 23 receives the parallel data input P$i$ for the cell, and is controlled by a signal IPL.

Thus, when ISH is high and IPL is low, the output of gate 22 is equal to the data received at the serial input S$i$. When ISH is low and IPL high, the output of gate 22 is equal to the parallel data bit P$i$. If both ISH and IPL are high, the output of the gate 22 is the exclusive -OR of the serial and parallel data inputs.

The output of the gate 22 is connected to one input of a multiplexer 24, the output of which is fed to the data input of a flip-flop (bistable circuit) 25. The output of the flip-flop is connected to the other input of the multiplexer 24, and also to the data output D$i$ of the cell.

The multiplexer 24 is controlled by a signal HOLD. When HOLD is high, the multiplexer selects the output of the flip-flop 25, causing its current contents to be fed back to its inputs. Thus, the flip-flop is held frozen in its current state, regardless of the condition of its input data signals. When HOLD is low, the multiplexer 24 selects the outputs of the exclusive -OR gate 22, and this allows either the serial input data, the parallel input data, or their exclusive -OR function to be clocked into the flip-flop 25.

The flip-flop 25 is a master-slave flip-flop controlled by a two-phase clock. Such flip-flops are well known and so it is not necessary to describe it in detail.

The control signals ISH, IPL and HOLD are common to all cells B0-B31 in the register.

The data output D$i$ of each bit cell is connected to the serial data input S($i$ + 1) of the next cell, allowing the register to be operated as a shift register as will be described. The data output D31 of the last bit cell is connected to a serial data output terminal SDO.

The serial data input S0 of the first bit cell is connected to the output of a multiplexer 14 as shown in Figure 1. The multiplexer 14 is controlled by a signal FB1. When FB1 is low, the multiplexer selects a serial data input terminal SDI. When FB1 is high, it selects a feedback signal from another multiplexer 15. The multiplexer 15 is controlled by a signal FB2. When FB2 is low, it selects the output of an exclusive -OR circuit 16. The inputs of the exclusive -OR circuit are connected to the data outputs of bit cells B3, B4, B5 and B7. When FB2 is high, it selects the output of an exclusive -OR circuit 17, the inputs of which are connected to the data outputs of bit cells B0, B1, B21 and B31.

OPERATION

The register has a number of modes of operation, controlled by the signals HOLD, IPL, ISH, FB1 and FB2 as follows:

| Mode | HOLD | IPL | ISH | FB1 | FB2 |
|---|---|---|---|---|---|
| HOLD | H | X | X | X | X |
| USER | L | H | L | X | X |
| SHIFT | L | L | H | L | X |
| GENERATE | L | L | H | H | L |
| ANALYSE | L | H | H | H | H |

In the HOLD mode, since the signal HOLD is high, the contents of all the bit cells are frozen and cannot be shifted or overwritten.  In all the other modes, HOLD is low.

The USER mode is the normal mode of operation, when the register is serving its normal function as a parallel input buffer to the logic circuit 10.  In this mode, IPL is high and ISH low and hence each bit cell $B\underline{i}$ selects its parallel data input $P\underline{i}$, allowing data to be loaded in parallel into the flip-flops 25 at each clock beat.

In the SHIFT mode, IPL is low and ISH high. Hence, each bit cell $B\underline{i}$ selects its serial data input $S\underline{i}$.  Since FB1 is low, the multiplexer 14 selects the serial data input terminal SDI.  Thus, in this mode, data is shifted serially through the register, between the terminals SDI and SDO.  This mode can be used to load test data into the register 12, or to read out its contents for diagnostic purposes.

In the GENERATE mode, each bit cell again selects its serial data input, and hence the register again operates as a shift register.  In this case, FB1 is held high and FB2 low, so that the multiplexers 14,15 select the output of the exclusive -OR circuit 16 as the feedback signal to the first bit cell BO.  Hence, in this mode, the register acts as feedback shift register, for generating sequences of pseudo-random numbers for testing the logic circuit 10.

It should be noted that in this mode the feedback connections to the register are all confined to the first eight bit cells BO-B7.  Hence, the length of the full pattern sequence is $2^8-1 = 255$.  This pattern sequence is shifted along the register into the remaining 24 bit cells B8-B31, so that each eight-bit pattern produced by BO-B7 is applied sequentially to every group of eight adjacent bits in the register.  The test sequence must be extended by 24 cycles, to allow time for the last pattern to reach the last group of bit cells B24-B31.

In the ANALYSE mode, both IPL and ISH are high, so that each bit cell forms the exclusive -OR combination of its parallel data input $\underline{Pi}$ and serial data input $\underline{Si}$. Thus, at each clock beat, the contents of the register are shifted and combined with the parallel input P0-P31.

Also, in this mode, both FB1 and FB2 are high, so that the multiplexers 14,15 now select the output of exclusive -OR circuit 17 as the feedback signal to the first bit cell. The connections to this circuit 17 are such that the register acts as a linear feedback shift register with a sequence length of $2^{32}-1$.

In this mode, the register can be used as a digital signature analyser, for generating a digital signature from a sequence of parallel inputs. This can be used for testing the logic circuits, not shown, which supply the input data P0-P31.

It will be appreciated that, while in the above example a 32-bit register was described, the invention is equally applicable to other register sizes. Also, while in the above example the feedback connections (through the circuit 16) are restricted to the first eight stages of the register, this can also be varied.

CLAIMS:-

1.      A digital integrated circuit comprising a logic circuit (10) having a plurality of inputs, connected to respective outputs (D0-D31) of an $\underline{n}$-stage shift register (12) having a feedback circuit (16) for applying a feedback signal to the first stage (B0) of the shift register to cause the shift register to act as a linear feedback shift register, the feedback circuit having connections from the outputs of predetermined stages of the shift register, characterised in that said connections are confined to the first $\underline{m}$ stages of the shift register where $\underline{m}$ is less than $\underline{n}$.

2.      A circuit according to Claim 1 wherein said feedback circuit (16) is so connected as to cause the register (12) to act as a linear feedback shift register with a sequence length equal to $2^m-1$.

3.      A circuit according to either preceding claim wherein $\underline{n}$ is greater than 20 and $\underline{m}$ is less than 20.

4.      A circuit according to any preceding claim wherein $\underline{n}$ is at least twice $\underline{m}$.

5.      A circuit according to any preceding claim including a further feedback circuit (17) with connections not confined to the first $\underline{m}$ stages of the register (12) and including a connection to the last stage (B31) of the register, and switching means (19) for selecting said feedback signal either from the first-mentioned feedback circuit (16) or from the further feedback circuit (17).

6.      A circuit according to any preceding claim wherein the shift register (12) is alternatively operable as a digital signature analyser for forming a digital signature characteristic of a sequence of inputs to the shift register.

7.      A circuit according to any preceding claim wherein the logic circuit (10) consists of a repetitive logic structure.

**0 206 468**

8.     A circuit according to any preceding claim wherein the shift register (12) is integrated on the same integrated circuit chip as the logic circuit.

*111*

## Fig.1.

## Fig.2.

# EUROPEAN SEARCH REPORT

**European Patent Office**

**0 206 468**

| | DOCUMENTS CONSIDERED TO BE RELEVANT | | EP 86302993.0 |
|---|---|---|---|

| Category | Citation of document with indication, where appropriate, of relevant passages | Relevant to claim | CLASSIFICATION OF THE APPLICATION (Int. Cl.4) |
|---|---|---|---|
| D,A | US - A - 3 961 252 (EICHELBERGER) <br> * Fig. 1,2; abstract * <br> -- | 1 | G 01 R 31/28 <br> G 06 F 11/22 |
| A | US - A - 3 961 254 (CAVALIERE) <br> * Abstract * <br> ---- | 1 | |

**TECHNICAL FIELDS SEARCHED (Int. Cl.4)**

G 01 R 15/00
G 01 R 31/00
G 06 F 11/00
H 03 K 19/00

The present search report has been drawn up for all claims

| Place of search | Date of completion of the search | Examiner |
|---|---|---|
| VIENNA | 30-09-1986 | KUNZE |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82